# FASCICULE DE BREVET EUROPEEN

(11) **EP 0 349 360 B1**
(45) Date de publication et mention de la délivrance du brevet: **12.05.1993**
(21) Numéro de dépôt: 89401579.1
(22) Date de dépôt: 07.06.1989
(51) Int. Cl.: G01R 33/12

(54) **Procédé pour caractériser magnétiquement la couche d'enregistrement d'un support magnétique d'informations**
Verfahren zur magnetischen Charakterisierung der Registrierungsschicht eines magnetischen Informationsträgers
Process for magnetically characterizing the registration layer of a magnetic information support

(30) Priorité: 29.06.1988 FR 8808773
(43) Date de publication de la demande: 03.01.1990
(73) Titulaire: BULL S.A., 92800 Puteaux (FR)
(72) Inventeur: Combettes, Christian, F-28560 Bercheres S/Vesgre (FR); Lefebvre, René, F-78180 Montigny Le Bretonneux (FR)
(74) Mandataire: Gouesmel, Daniel

(56) Documents cités:
- FR-A- 2 522 857
- US-A- 3 686 682
- US-A- 3 781 835
- HEWLETT-PACKARD JOURNAL, vol. 36, novembre 1985, pages 11-20, Amstelveen, NL; J. HODGES et al.: "Dynamic testing of thin-film magnetic recording discs"

## Description

La présente invention concerne un procédé caractériser magnétiquement la couche d'enregistement d'un support magnétique d'informations et le dispositif mettant en oeuvre ce procédé. Elle est plus particulièrement applicable à la caractérisation des tambours magnétiques d'imprimantes magnétographiques, ou encore des disques magnétiques de mémoires à disques.

Les imprimantes magnétographiques sont désormais bien connues et trouvent une utilisation préférée dans les systèmes de traitement de l'information où l'on recherche des machines imprimantes permettant d'obtenir l'impression de caractères de grande lisibilité avec des vitesses d'impression extrêmement élevées (plusieurs milliers voire dizaine de milliers de lignes par minute).

On trouve la description d'une telle imprimante dans le brevet français n° 2.522.857 déposé le 3 mars 1982. Une telle machine imprimante magnétographique (encore appelée machine non-impact magnétique) comprend un support d'enregistrement magnétique constitué par un tambour magnétique formé lui-même d'un shunt magnétique constituant sa partie centrale sur lequel est déposée une couche d'enregistrement magnétique. La machine comprend également un ensemble de têtes d'enregistrement magnétique placées les unes à côté des autres parallèlement à l'axe de rotation du tambour. Ces têtes magnétiques permettent de créer des domaines magnétisés, encore appelés points magnétiques, sur la surface de la couche d'enregistrement du tambour, lequel est animé d'un roulement de rotation uniforme. On forme ainsi des zones magnétisées formées d'un ensemble de domaines magnétiques, ayant une forme correspondant à celle des caractères que l'on cherche à imprimer. Ces domaines magnétisés sont revêtus ensuite, au moyen d'un dispositif de révélation, de particules d'un pigment magnétique pulvérulent. Ce dernier est constitué par exemple de particules magnétiques enduites d'une résine. Celle-ci est susceptible de fondre quand on la chauffe, et de se fixer sur le papier d'impression sur lequel elle est appliquée. Le pigment magnétique adhère sur les ensembles de domaines magnétiques définis ci-dessus en formant un dépôt de particules à la surface du tambour. Ces particules sont ensuite transférées sur une feuille de papier appliquée contre le tambour par un rouleau de transfert. Puis les particules qui subsistent sur le tambour sont enlevées par un dispositif d'effacement.

A la lumière de ce qui est rappelé ci-dessus, on voit clairement qu'un des organes essentiels d'une imprimante magnétographique est le tambour magnétique. En effet, de ses propriétés magnétiques et de l'homogénéité de celles-ci sur toute sa surface, dépend la qualité d'impression des caractères et son homogénéité sur toute la surface du papier d'impression.

Il est donc particulièrement important de pouvoir s'assurer qu'à la suite des différentes opérations de fabrication successives permettant d'élaborer le tambour, celui-ci présente sur toute sa surface des propriétés magnétiques conformes à des normes de référence établies d'avance, par exemple par expérimentation. Ces normes définissent les caractéristiques magnétiques standards minimum qu'il doit posséder, afin que les qualités d'impression soient correctes (courbe de première aimantation piste par piste, perméabilité en résultant, champ coercitif, et ce sur toute la surface du tambour). "Déterminer les caractéristiques magnétiques du tambour" est encore appelé "caractériser magnétiquement le tambour".

Il importe donc de pouvoir contrôler les caractéristiques magnétiques de ce tambour, dès que les opérations de fabrication du tambour sont terminées, et ce avant que ce dernier ne soit revêtu d'une couche de protection mécanique contre les chocs et la corrosion. (Couche constituée par exemple de chrome).

Dans les circonstances actuelles, on procède de la manière suivante : en même temps que l'on dépose la couche d'enregistrement magnétique sur le shunt magnétique constituant la partie centrale du tambour, on constitue un échantillon représentatif de ce dernier. Il est constitué par une éprouvette constituée de laiton sur laquelle on dépose un matériau magnétique strictement identique (matière le constituant, épaisseur) à celui qui constitue la couche d'enregistrement du tambour. L'on mesure les différentes caractéristiques magnétiques de cet échantillon, au moyen par exemple d'un magnétomètre du commerce ou d'un fluxmètre classique. On vérifie si ces propriétés sont conformes aux normes de référence définies plus haut. Si cela est le cas, on envoie ensuite le tambour dans un atelier de chromage où il est revêtu de sa couche protectrice de chrome.

Il est clair que la caractérisation de cet échantillon ne peut refléter exactement les propriétés magnétiques du tambour dans sa totalité. Il arrive d'ailleurs fréquemment, qu'au retour de l'atelier de chromage, l'on constate que le tambour magnétique ne possède pas sur la totalité de sa surface les propriétés magnétiques que l'on exige de lui pour assurer une qualité d'impression correcte. Il faut donc le mettre au rebut, ce qui coûte très cher.

On connaît une méthode (telle qu'elle est définie dans le préambule de la présente revendication 1) support d'enregistrement magnétique, tel qu'un disque magnétique. Une telle méthode est par exemple, décrite dans le brevet US-A-3 686 682. Cette méthode consiste à enregistrer une paire de transitions magnétiques à des intervalles déterminés le long d'une piste d'enregistrement du disque, ces transitions produisant à la lecture une paire d'impulsions logiques à des intervalles périodiques tout au long de la lecture d'une même piste. On mesure à la fois l'intervalle de temps qui sépare les pics de chaque paire d'impulsions et l'amplitude de ces pics par rapport à une amplitude moyenne des impulsions enregistrées. On obtient ainsi des renseignements sur la qualité de surface de chaque piste d'enregistrement du disque, aussi bien que sur la qualité et l'espacement de la tête magnétique par rapport au disque. On peut détecter également s'il y a des impulsions manquantes. La méthode comporte plus précisément les opérations suivantes :
- on efface magnétiquement la couche du support d'enregistrement sur toute la surface de la piste de manière à rendre neutre son état magnétique,
- on écrit ensuite sur toute cette même surface une suite de domaines magnétiques au moyen d'un champ magnétique produit par un courant d'écriture périodique,
- on lit ensuite à des instants d'échantillonnage déterminés une tension fonction de l'alimentation à l'intérieur de chacun des domaines lus à ces instants,
- on mémorise ces tensions et on en extrait la valeur moyenne,
- on utilise un dispositif de visualisation.

Toutefois, cette méthode ne permet pas d'établir les caractéristiques magnétiques du support d'enregistrement magnétique, en particulier, d'établir en temps réel la courbe de première aimantation du support d'enregistrement magnétique pour chacune des pistes.

La présente invention permet de remédier à ces inconvénients en réalisant un procédé permettant de caractériser la couche d'enregistrement magnétique d'un tambour magnétique d'impression, dès que les opérations de fabrication concernant celui-ci sont terminées (avant chromage). Cette caractérisation a lieu pour toute la surface de la couche d'enregistrement de ce tambour, et est très rapide. Elle permet de connaître les caractéristiques magnétiques de la couche d'enregistrement sur toute la surface de celui-ci et de vérifier si ces caractéristiques sont homogènes, non seulement sur une piste déterminée du tambour mais aussi sur l'ensemble des pistes d'enregistrement de celui-ci.

Cette invention permet, si un tambour ne présente pas les caractéristiques magnétiques requises par rapport aux normes de référence, de renvoyer celui-ci en fabrication et par conséquent, d'éviter de mettre un certain nombre de tambours magnétiques au rebut, comme c'était le cas dans la pratique antérieure. On réalise ainsi de substantielles économies, ce qui permet de réduire de manière appréciable le prix de revient moyen des tambours. Cette invention s'inscrit donc dans le processus d'amélioration de la qualité pour ce qui concerne la fabrication du tambour.

Il est clair que le procédé selon l'invention peut être utilisé aussi bien par les services de fabrication de l'entreprise produisant le tambour magnétique, que par ses propres services de maintenance.

Selon l'invention, le procédé pour établir les caractéristiques magnétiques de première aimantation de la couche d'enregistrement d'un support magnétique d'informations mobile comportant une pluralité de pistes d'enregistrement ayant chacune un index de synchronisation repéré par des moyens de repérage qui délivrent une impulsion de synchronisation à chaque passage de l'index devant eux, dans lequel, pour chaque piste, on effectue au moins une séquence comprenant les opérations suivantes :
1) on efface magnétiquement la couche sur toute la surface de la piste de manière à rendre neutre son état magnétique,
2) on écrit ensuite sur toute cette même surface une suite de domaines magnétiques au moyen d'un champ magnétique produit par un courant d'écriture périodique,
3) on lit ensuite à des instants d'échantillonnage déterminés une tension fonction de l'aimantation à l'intérieur de chacun des domaines lus à ces instants,
4) on mémorise ces tensions et on en extrait la valeur moyenne et on les visualise au moyen d'un dispositif de visualisation, caractérisé en ce qu'il comprend en outre, une suite de séquences distinctes au nombre de p, où p est un nombre entier, où, lors de chaque séquence, les opérations 1) à 4) comprennent en outre les particularités suivantes :
   1/ l'effacement de la couche a lieu dès réception d'une première impulsion de synchronisation ,
   2/ A la réception d'une seconde impulsion de synchronisation, ledit courant d'écriture a une amplitude déterminée, la suite des amplitudes étant croissante, l'amplitude maximum étant la valeur de l'amplitude pour laquelle la couche magnétique est saturée, l'amplitude minimum étant la valeur la plus proche de zéro, le courant d'une amplitude déterminée étant appliqué lors de l'opération 2) de la séquence correspondante, dès réception de ladite seconde impulsion de synchronisation,
   3/ Dès réception d'une troisième impulsion de synchronisation, la lecture s'effectue aux dits instants d'échantillonnage avec une période d'échantillonnage déterminée supérieure à la période du courant d'écriture, la tension lue à ces mêmes instants d'échantillonnage est en fonction de l'aimantation à l'intérieur de chacun des domaines lus à ces instants, de telle sorte qu'on obtient une pluralité de valeurs de tension lue pour une même valeur d'amplitude du courant,
   4/ On mémorise l'ensemble des valeurs des tensions lues et la valeur de l'amplitude de courant (Ij) correspondante, et on extrait au moins de cet ensemble la valeur moyenne de la tension lue, la courbe moyenne de première aimantation incluant l'ensemble de ces valeurs moyennes, étant représentée en fonction de ces valeurs des amplitudes de courant sur ledit dispositif de visualisation, dès que la dernière des séquences est terminée.

D'autres caractéristiques et avantages de la présente invention apparaîtront dans la description suivante donnée à titre d'exemple non limitatif et en se référant aux figures annexées.
La figure 1 montre sous forme de schéma simplifié les différents éléments constitutifs essentiels du dispositif de mise en oeuvre du procédé selon l'invention, plus communément appelé magnétomètre dynamique,
La figure 2 est une vue en perspective montrant comment est réalisé le transducteur d'écriture dudit dispositif,
La figure 3, composée des figures 3a et 3b est une vue plus détaillée de la figure 1, montrant en particulier comment sont constitués les moyens de génération du courant d'écriture alimentant le transducteur d'écriture, et les moyens de lecture délivrant le signal S,
La figure 4 est un chronogramme montrant le courant d'écriture délivré par les moyens de génération du courant d'écriture,
La figure 5 montre une piste d'enregistrement du tambour où sont enregistrés une pluralité de domaines magnétiques d'aimantation successive positive et négative,
La figure 6 est un chronogramme de signaux permettant d'illustrer le fonctionnement du dispositif de mise en oeuvre du procédé selon l'invention montré aux figures 1 et 3,
Les figures 7 et 8 qui sont respectivement des vues de dessus et en coupe, montrent une forme de réalisation préférée dudit dispositif permettant de caractériser magnétiquement toute la surface d'enregistrement d'un tambour magnétique pour imprimante magnétographique,
La figure 9 montre les différentes courbes de caractérisation obtenues.

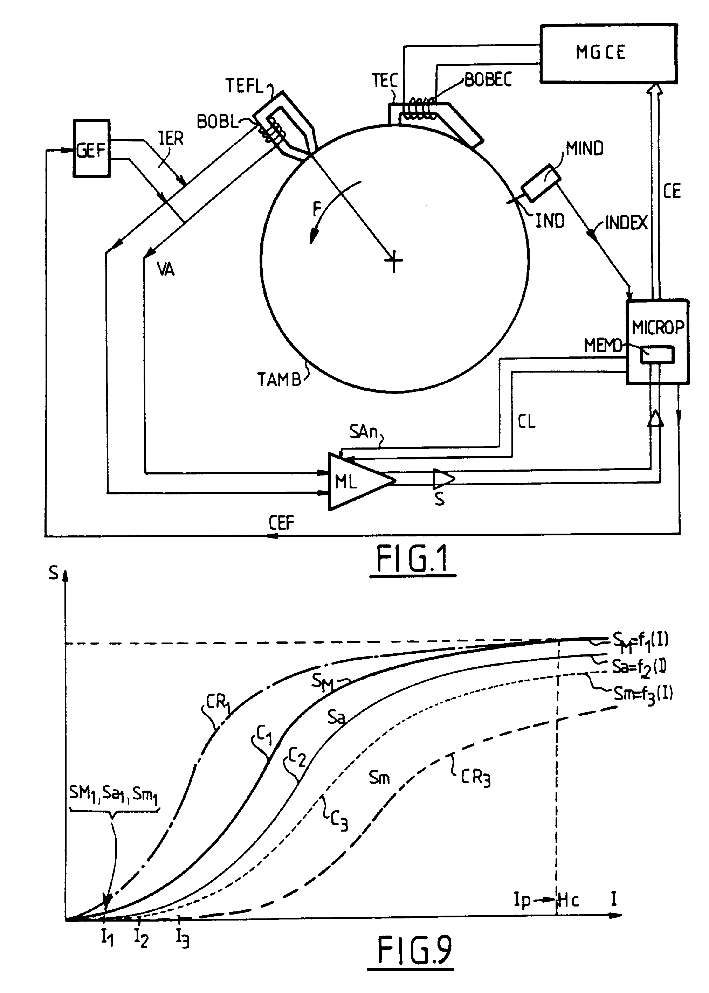

On considère la figure 1 qui montre les différents éléments constitutifs essentiels d'un magnétomètre dynamique pour mettre en oeuvre le procédé selon l'invention, à savoir MD, destiné à caractériser magnétiquement le tambour magnétique TAMB.

Ce magnétomètre dynamique MD comprend :
- des moyens MIND de repérage de l'index de synchronisation IND placé sur chaque piste d'enregistrement du tambour,
- un transducteur TEC d'écriture d'informations (de domaines magnétiques) sur chaque piste P du tambour TAMB, connecté à des moyens de génération MGCE d'un courant d'écriture SC,
- un transducteur TEFL d'effacement et de lecture assurant d'une part la fonction d'un transducteur d'effacement des informations enregistrées sur chaque piste de la couche magnétique d'enregistrement du tambour et d'autre part la fonction d'un transducteur de lecture des informations enregistrées sur chaque piste P par le transducteur d'écriture TEC,
- des moyens ML de lecture connectés au transducteur de lecture TEFL, qui délivrent un signal S, ce signal étant envoyé dans une mémoire MEMO, laquelle contient également la valeur de l'intensité du courant d'écriture SC.

La mémoire MEMO est contenue dans un organe de commande programmable MICROP, qui de préférence est un microprocesseur, lequel commande par ailleurs les opérations d'effacement, d'écriture, et de lecture des informations, respectivement effectuées par les transducteurs TEFL, TEC, TEFL.

Le tambour TAMB est un tambour cylindrique de section circulaire, dont la couche d'enregistrement magnétique est formée d'un alliage de cobalt, de nickel et de phosphore Co-Ni-P d'environ 25 micromètres d'épaisseur déposée sur une sous-couche de cuivre de 0,8 micromètre d'épaisseur elle-même déposée sur un shunt magnétique en alliage de fer et silicium Fe-Si de 100 mm de diamètre.

Chaque piste d'enregistrement P du tambour TAMB contient un index IND de synchronisation permettant de repérer de manière arbitraire le début de chaque piste P. Il est évident que tous les index IND des pistes du tambour TAMB sont alignés sur une même génératrice de celui-ci. Ils sont constitués par exemple par des repères optiques inscrits sur la surface de ce tambour.

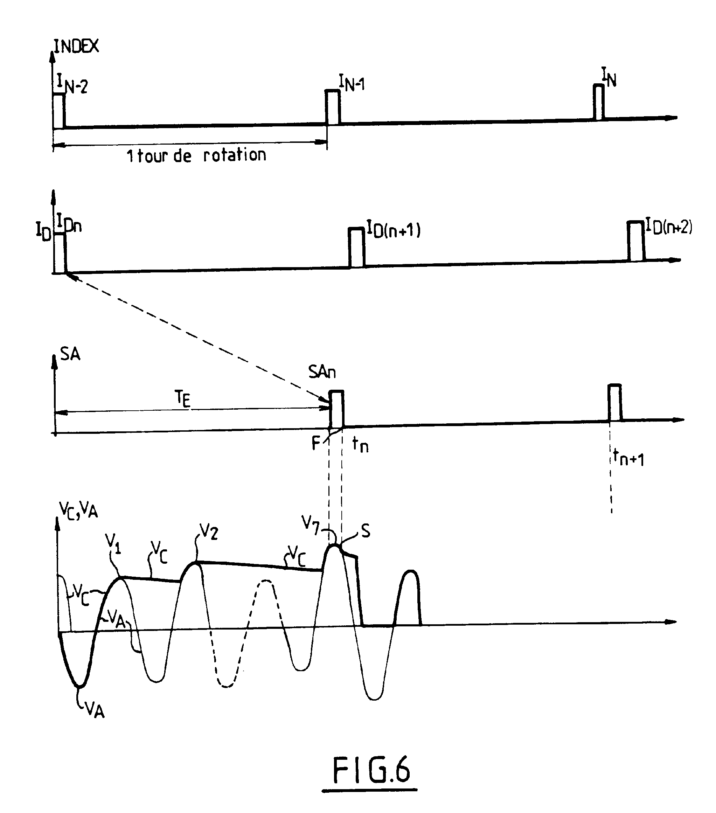

Les moyens de repérage MIND sont constitués par exemple par des transducteurs photoélectroniques délivrant une impulsion électrique I_{N} (voir figure 6) dès que l'idex IND d'une piste donnée P passe devant eux.

Le transducteur d'effacement et de lecture TEFL est de préférence constitué par une tête inductive du type de celle couramment utilisée dans les dérouleurs de bandes magnétiques, et fabriquée par exemple par la Société "Etablissements Vedette" à Saverne, 67000 FRANCE, et vendue par la Société BULL sous la référence 993 609 000-01. Cette tête inductive TEFL comporte donc un bobinage BOBL.

Lorsque le transducteur TEFL fonctionne en tant que transducteur d'effacement ce bobinage BOBL est alimenté par un générateur GEF d'un courant d'effacement I_{ER} lui-même commandé par l'organe de commande programmable MICROP.

Lorsqu'il fonctionne comme transducteur de lecture, son bobinage BOBL délivre un signal analogique v_{A} aux moyens de lecture ML qui le transforment en un signal numérique S qui est envoyé à la mémoire MEMO du microprocesseur MICROP. Les moyens de lecture ML sont commandés par un signal de commande de lecture CL envoyé par l'organe de commande programmable MICROP suivant des modalités qui seront décrites plus loin.

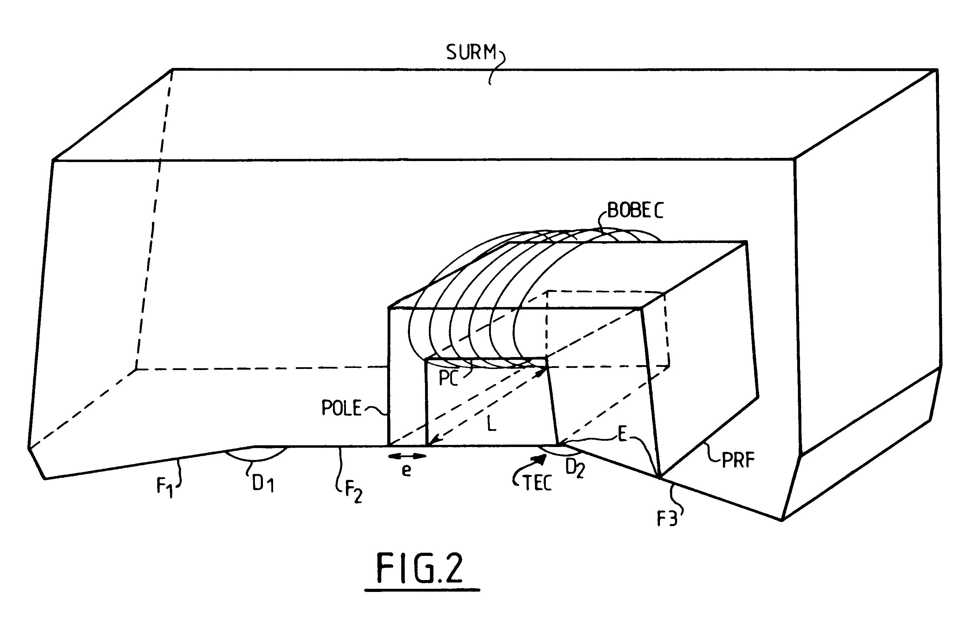

Le transducteur d'écriture TEC est un transducteur du type inductif comportant un bobinage BOBEC. Un mode de réalisation préféré de ce transducteur est montré à la figure 2. Ce transducteur TEC est du type décrit dans le brevet français n° 2.522.857 précité. Il est du type sabot, à enregistrement perpendiculaire, et comporte donc un pôle d'écriture POLE et un pôle de retour de flux PRF. L'épaisseur e du pôle d'écriture POLE mesurée selon une direction parallèle au sens de défilement des pistes du tambour devant le transducteur est très sensiblement inférieure à l'épaisseur E du pôle de retour de flux PRF de manière que une fois les informations écrites par le pôle d'écriture POLE, ces dernières ne soient pas perturbées par le pôle de retour de flux PRF. La section du pôle d'écriture POLE est sensiblement rectangulaire et a une largeur L. L'ordre de grandeur des dimensions e et L est le suivant : 0,1 mm pour e et 4,8 mm pour L. De façon connue, le circuit magnétique du transducteur d'écriture TEC est constitué par un matériau à forte perméabilité magnétique. Le bobinage BOBEC est disposé sur la partie centrale PC du circuit magnétique qui relie le pôle d'écriture POLE au pôle de retour de flux PRF.

Le transducteur d'écriture TEC est de préférence noyé dans un surmoulage SURM ayant une largeur supérieure à la largeur du transducteur TEC et est fait d'une matière amagnétique telle qu'une résine thermodurcissable. La face inférieure du surmoulage SURM destinée à être disposée en regard du tambour TAMB, est composée de trois faces planes adjacentes, à savoir les faces F₁, F₂, F₃, la face F₂ étant comprise entre les faces F₁ et F₃, les droites d'intersection de F₁ et F₂, d'une part, F₂ et F₃, d'autre part, étant parallèles. La face F₁ forme un angle dièdre D₁ avec la face F₂, cette dernière faisant un angle dièdre D₂ avec la face F₃. L'angle dièdre D₁ est supérieur à l'angle dièdre D₂. Cette structure du surmoulage permet à l'ensemble formé par le surmoulage et le transducteur TEC d'être tangent au tambour TAMB, au droit du pôle d'écriture POLE. Ce dernier est donc en contact permanent avec la surface du tambour TAMB.

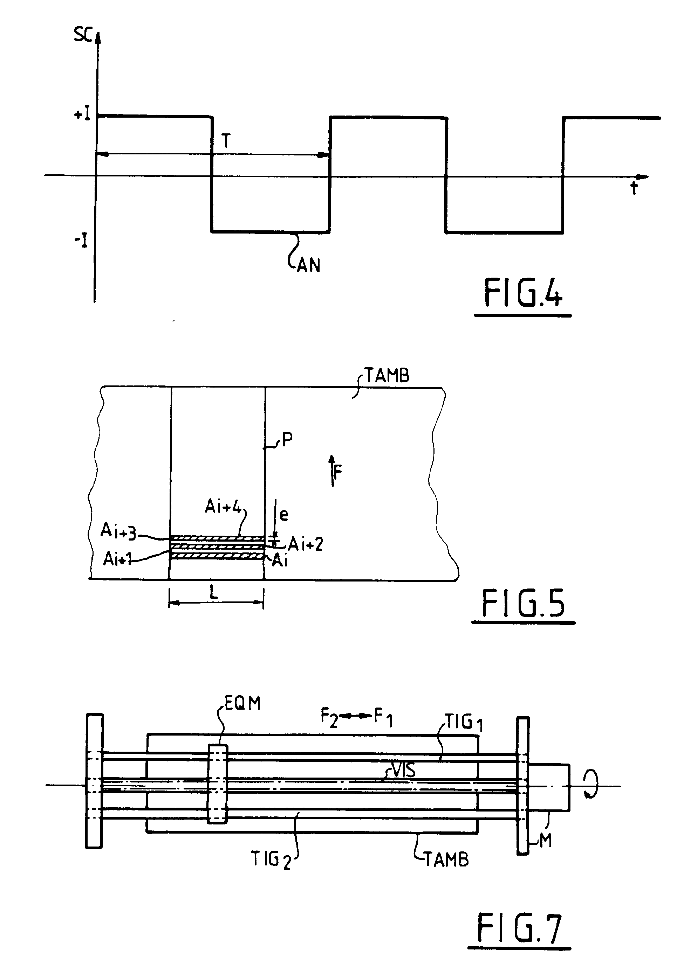

Pendant les opérations d'écriture le microprocesseur MICROP envoie un courant de commande d'écriture CE sous forme digitale aux moyens de génération de courant d'écriture MGCE, lesquels tranforment ce courant de commande digital et un courant d'écriture analogique SC ayant par exemple une forme carrée comme l'indique la figure 4. La période de ce courant d'écriture SC est égale à T, son amplitude égale à I. Ce courant SC est à alternance successivement positive et négative et l'intensité de celui-ci varie donc entre - I et + I.

Ce courant d'écriture SC alimente le bobinage BOBEC du transducteur d'écriture TEC.

Le fonctionnement du magnétomètre dynamique MD est régi par le procédé décrit ci-dessous, en relation avec les figures 1, 4, 5, 6.

On suppose que l'on cherche à caractériser magnétiquement une piste donnée P du tambour qui tourne avec une vitesse de rotation uniforme V dans le sens de la flèche F, celle-ci étant par exemple de l'ordre de 30 tours par minute.

A chaque tour de rotation, lorsque l'index IND passe devant les moyens de repérage MIND, ceux-ci délivrent une impulsion I_{N} de forme rectangulaire. Ainsi, comme montré à la figure 6, les moyens MIND, délivrent une succesion d'impulsions I_{N-2}, I_{N-1}, I_{N}, I_{N+1}, ..., la durée séparant chacune de ces impulsions étant égale à la durée de rotation d'un tour de tambour.

On considère par exemple l'impulsion I_{N-2}.

Dès qu'elle retombe à zéro, commence la séquence SEQ₁ des trois opérations suivantes :

### 1) OPÉRATION D'EFFACEMENT :

Dès que cette impulsion I_{N-2} parvient au microprocesseur MICROP, celui-ci envoie un signal de commande d'effacement CEF au générateur d'effacement GEF. Ce dernier envoie alors, en réponse à ce courant CEF un courant d'effacement I_{ER} bobinage BOBL du transducteur d'effacement TEFL. Ce courant d'effacement peut être aussi bien un courant continu, par exemple d'intensité égale à 150 milliampères, qu'un courant alternatif, par exemple de fréquence 7 kHz, et d'amplitude 150 milliampères. L'effacement de la piste P du tambour a lieu pour un tour complet de ce dernier, c'est-à-dire jusqu'à ce que les moyens de repérage de l'index MIND délivrent l'impulsion qui succède à l'impulsion I_{N-2}, à savoir l'impulsion I_{N-1}. Cet effacement a pour résultat essentiel le fait que la couche d'enregistrement magnétique du tambour est rendue magnétiquement neutre (aimantation à l'intérieur de la couche nulle).

Dès que le microprocesseur MICROP reçoit l'impulsion I_{N-1}, commence alors l'opération d'écriture des informations sur la piste P du tambour.

### 2) OPÉRATION D'ÉCRITURE :

Le microprocesseur MICROP envoie un signal de commande d'écriture CE aux moyens MGCE. Ces derniers transforment le courant de commande d'écriture CE écrit sous forme digitale en un courant carré SC (voir figure 4 et description ci-dessus). Le transducteur d'écriture TEC écrit alors sur la piste P une succession de domaines magnétiques rectangulaires ayant sensiblement la dimension de la section du pôle d'écriture POLE. On obtient ainsi une succession de domaines magnétiques où les aimantations sont successivement positives et négatives, à savoir les domaines Aᵢ, Aᵢ₊₁, Aᵢ₊₂, Aᵢ₊₃, Aᵢ₊₄, ..., les domaines magnétiques Aᵢ, Aᵢ₊₂, Aᵢ₊₄ ayant par exemple des aimantations positives alors que les domaines Aᵢ₊₁, Aᵢ₊₃, ..., ont des aimantations négatives (voir figure 5). La direction du vecteur aimantation dans ces domaines est perpendiculaire à la surface du tambour. On voit que la piste P écrite a une largeur L, chacun des domaines écrits ayant une longueur mesurée selon une direction parallèle au sens de défilement F du tambour égale à e. La première opération d'écriture qui s'effectue dans le temps s'effectue pour un courant SC dont l'amplitude I est égale à I₁ avec I₁ non nul mais voisin de 0 (voir figure 9). On peut choisir, par exemple, I₁ égal 1 milliampère.

Lorsque les moyens de repérage MIND délivrent l'impulsion I_{N}, l'opération d'écriture est terminée. Il convient de préciser que pendant cette opération d'écriture, les moyens de lecture ML sont inhibés. Dès que le microprocesseur MICROP reçoit l'impulsion I_{N}, l'opération de lecture commence.

### 3) OPÉRATION DE LECTURE :

Le microprocesseur MICROP envoie alors un signal de commande de lecture CL aux moyens de lecture ML qui peuvent alors fonctionner. Le bobinage BOBL du transducteur de lecture TEFL délivre alors le signal v_{A} aux moyens de lecture ML. Ce signal v_{A} est un signal périodique dont la période est égale à T. Il a une forme sensiblement sinusoïdale présentant une suite d'alternances positives et négatives, l'amplitude des alternances positives étant successivement V₁, V₂, ..., Vₙ. Dès que le microprocesseur a reçu l'impulsion I_{N}, il délivre aux moyens ML une succession d'impulsions d'échantillonnage SAₙ, SAₙ₊₁, ..., dont la période d'échantillonnage T_{E} est égale à plusieurs fois la période T, par exemple 7 fois dans un mode de réalisation préféré de l'invention. (Il est clair qu'à la figure 6, l'échelle des temps est différente pour les signaux I_{N}, d'une part, I_{Dn}, S_{An} et V_{A} d'autre part). Dès que les moyens de lecture ML reçoivent l'une des impulsions d'échantillonnage SAₙ, SAₙ₊₁, ..., ils prélèvent la valeur de l'amplitude positive du signal v_{A} à l'instant tₙ où est émise l'impulsion SAₙ et transforme celle-ci en un signal numérique S₁ qui est envoyé à la mémoire MEMO. Le signal numérique S₁ est formé par exemple par un ensemble de 10 bits logiques égaux à 0 ou 1. Dans un exemple d'application numérique de l'invention, le tambour ayant une circonférence de 314 mm (diamètre égal à 100 mm), la longueur e d'un domaine magnétique étant de 0,1 mm, on voit que, par tour, il y a 1570 couples de domaines magnétiques positifs et négatifs tels que Aᵢ-Aᵢ₊₁, et que par conséquent le signal V_{A} comporte 1570 périodes. Etant donné que T_{E} est égal sensiblement à 7 T, on voit que l'on pourra prélever par échantillonnage, plus de 200 valeurs de S₁ qui seront envoyées dans le mémoire MEMO, et ce, pour un même tour de rotation du tambour, pour une même valeur de I₁.

Le microprocesseur MICROP comporte un programme de calcul lui permettant d'extraire parmi les 200 points de mesure, la valeur maximum S_{M1}, la valeur minimum Sₘ₁ et la valeur moyenne de l'ensemble des valeurs S₁ relevées pour un même tour de rotation du tambour.

Dès que l'opération de lecture est terminée, c'est-à-dire dès que les moyens MIND délivrent l'impulsion d'index I_{N+1}, on procède à une seconde séquence SEQ₂ de trois opérations, mais avec un courant d'écriture I₂, tel que :
I₂ - I₁ = Δ I.

La séquence d'opérations SEQ₂, se déroule dans le même ordre que précédemment, c'est-à-dire successivement effacement, écriture, lecture. On obtient ainsi trois valeurs de signal S_{M2}, Sₐ₂, Sₘ₂ qui correspondent à la valeur du courant I₂.

Dès que la séquence SEQ₂ est terminée, on procède à la séquence SEQ₃, identique aux deux précédentes, mais pour un courant I₃ avec I₃ - I₂ = ΔI, avec des valeurs de signaux S_{M3}, Sₐ₃, Sₘ₃.

On procède ensuite de la même manière pour une suite de séquences d'opérations SEQ₄, SEQ₅, ..., jusqu'à la séquence d'opérations SEQₚ où p dépend de la précision que l'on recherche pour établir la courbe S = f(I). Iₚ est la valeur de I pour laquelle est obtenue l'aimantation de saturation de la couche magnétique. Il est clair que la valeur de Δ I dépend des valeurs de Iₚ et de p. Dans la pratique, Δ I est de l'ordre de 1 à une dizaine de milliampères.

A l'ensemble de valeurs I₁, I₂, I₃, I₄, ..., Iₚ correspondent trois ensembles de valeurs, à savoir un premier ensemble S_{M1}, S_{M2}, ..., S_{Mp}, un second ensemble Sₐ₁, Sₐ₂, ..., Sₐₚ et un troisième ensemble Sₘ₁, Sₘ₂, ..., Sₘₚ.

A ces trois ensembles correspondent trois courbes de première aimantation S_{M} = F₁ (I), Sₐ = f₂ (I), Sₘ = f₃ (I), ces courbes étant dénommées respectivement C₁, C₂, C₃ et montrées à la figure 9.

Les courbes S = f (I) sont représentatives, à une constante près, de la courbe de première aimantation M = f (H) où M est l'aimantation à l'intérieur du matériau d'enregistrement et H le champ magnétique appliqué lors de l'opération d'écriture. En effet, H est proportionnel à I et M est proportionnel à S.

Ces courbes peuvent être visualisées directement sur un écran de terminal d'ordinateur, ce dernier incluant le microprocesseur MICROP.

Il est clair que pour un même courant I, on peut relever les variations de S sur un même tour, ce qu'on appelle encore modulation de lecture sur un tour, ce qui permet de vérifier l'homogénéité des caractéristiques magnétiques de la couche d'enregistrement sur un tour.

On peut encore considérer un tambour magnétique de référence dont les caractéristiques magnétiques sont jugées optimales et considérer respectivement les trois courbes C₁, C₂, C₃ relatives à ce tambour de référence et qui sont dénommées C_{R1}, C_{R2}, C_{R3} . Les courbes extrêmes C_{R1}, C_{R3} constituent une enveloppe à l'intérieur de laquelle doivent se situer toutes les courbes C₁, C₂, C₃ de tous les tambours dont on mesure les caractéristiques magnétiques au moyen du dispositif décrit. La comparaison entre ces différentes courbes peut donc être effectuée directement sur l'écran du terminal.

La caractérisation au moyen dudit dispositif d'un tambour magnétique a lieu, ainsi qu'il l'a été indiqué plus haut, dès que les différentes étapes de fabrication de ce même tambour sont terminées et ceci avant et/ou après chromage de ce dernier.

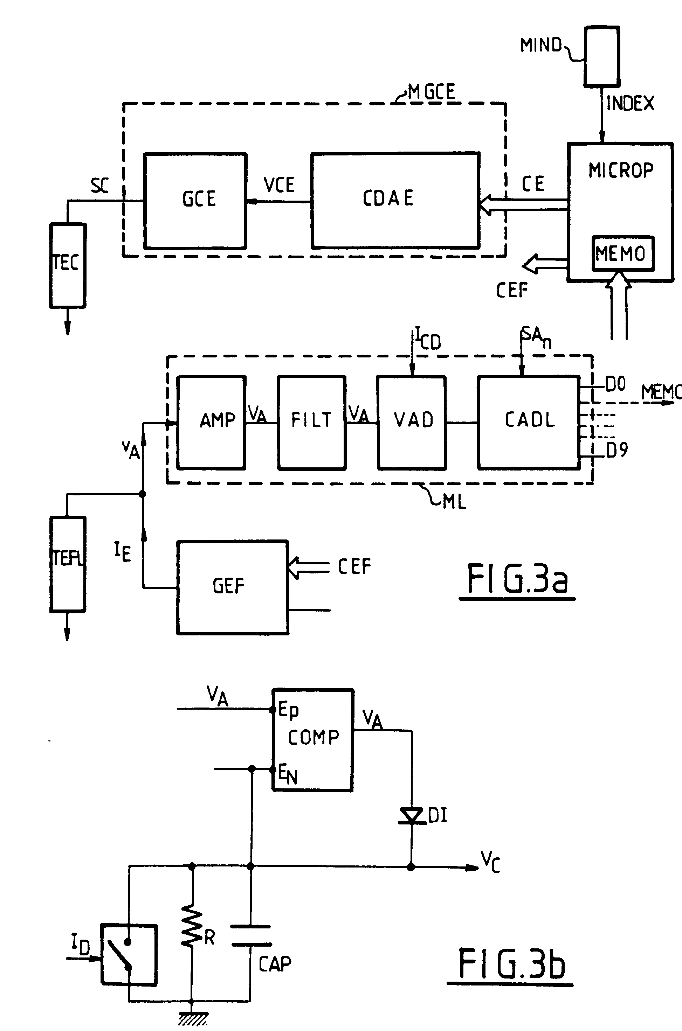

On considère les figures 3a et 3b.

Ainsi qu'on peut le voir à la figure 3a, les moyens de génération du courant d'écriture MGCE sont constitués par un convertisseur digital analogique CDAE et par un générateur de courant GCE placés en séries. Le convertisseur digital analogique CDAE reçoit le signal numérique de commande d'écriture CE qui est un ensemble de 8 bits logiques égaux à 0 ou 1 indiquant à la fois l'amplitude et la fréquence du signal carré SC. A cet ensemble de valeurs binaires envoyées par le microprocesseur MICROP correspond à la sortie du convertisseur digital analogique CDAE une suite d'impulsions de tension VCE transformée en une suite d'impulsions de courant par le générateur de courant GCE. Ce dernier délivre donc le signal carré SC représenté à la figure 4 qui a l'amplitude I et la fréquence désirées. La fréquence de ce courant est choisie de telle façon que la longueur e d'une information écrite soit égale ou supérieure à 0,1 mm.

Les moyens de lecture ML comprennent, placés en séries :
- le préamplificateur AMP,
- le filtre passe-bandes FILT,
- le voltmètre d'acquisition de données VAD,
- le convertisseur analogique digital de lecture CADL.

Le signal v_{A} issu du bobinage BOBL du transducteur de lecture TEML est envoyé à l'entrée du préamplificateur AMP, et amplifié par ce dernier en devenant le signal V_{A} qui est envoyé à l'entrée du filtre FILT du type à commutation de capacité, par exemple un filtre MF10 de la firme NS (National Semiconductors) et en ressort sous forme d'un signal de lecture sensiblement sinusoïdal de fréquence strictement égale à la fréquence du courant d'écriture. On voit que le rôle du filtre qui est calé sur la fréquence du courant d'écriture est de débarrasser le signal V_{A} de toutes ses harmoniques et de tous les signaux parasites. Le signal V_{A} ayant ainsi traversé le filtre est envoyé à l'entrée du voltmètre d'acquisition de données VAD dont les éléments constitutifs fonctionnels essentiels sont montrés à la figure 3b.

Ce voltmètre d'acquisition de données VAD est en fait un voltmètre de crête analogique.

Il comprend :
- un comparateur COMP ayant une entrée positive Eₚ et une entrée négative E_{N},
- une diode DI,
- un condensateur CAP aux bornes duquel sont montés en parallèle une résistance R, d'une part et un interrupteur INT, par exemple, un interrupteur à transistor, d'autre part.

La borne commune (non reliée à la masse) au condensateur CAP, à la résistance R et à l'interrupteur INT est également reliée à l'entrée négative E_{N} du comparateur COMP et à la cathode de la diode DI. Leur autre borne commune est reliée à la masse. La tension V_{A} est appliquée à l'entrée positive Eₚ du comparateur COMP dont la sortie est connectée à l'anode de la diode DI.

Pour comprendre le fonctionnement du voltmètre de crête VAD, on se reporte à la figure 6.

La tension V_{C} aux bornes du condensateur CAP, évolue de la manière indiquée à la figure 6, comme il va être détaillé ci-après.

Dès que l'impulsion d'index I_{N} est envoyée au microprocesseur MICROP, celui-ci envoie un signal de décharge I_{Dn} à l'interrupteur INT qui se ferme. Le condensateur CAP se décharge rapidement (avec une durée de l'ordre de celle de l'impulsion I_{Dn}, elle-même inférieure à celle d'une demi-alternance du signal V_{A}). A la figure 6, il a été supposé, pour simplifier la figure et le raisonnement, que cette décharge a lieu pendant une alternance négative du signal V_{A}. La tension V_{C} est donc nulle, à la fin de la décharge.

Une fois l'impulsion I_{Dn} retombée à zéro, l'interrupteur INT s'ouvre. Dès qu'apparaît alors la première alternance positive, du signal V_{A}, la diode DI est conductrice (puisque V_{A} > V_{C}) le condensateur se charge jusqu'à ce que sa tension aux bornes V_{C} soit égal à la tension de crête V₁ de cette alternance. Ensuite, quand V_{A} devient inférieure à V_{C}, la diode DI ne conduit plus et le condensateur CAP se décharge alors à travers la résistance R, très lentement, la période de décharge T_{D} égale au produit de R par la capacité du condensateur CAP étant de l'ordre de 100 fois la période T. Dès que la tension V_{A} redevient supérieure à V_{C}, la diode DI conduit et le condensateur CAP se charge à nouveau jusqu'à ce que, comme indiqué à la figure 6, sa tension V_{C} aux bornes soit égale par exemple à la tension de crête V₂ de la seconde alternance positive. Dès que V_{A} redevient inférieure à V₂, le condensateur CAP se décharge à nouveau à travers la résistance R (la diode DI ne conduisant plus) jusqu'à ce que V_{A} redevienne supérieure à V_{C}, ce qui est le cas pour la septième alternance représentée à la figure 6 où V_{C} devient alors égal à la tension de crête V₇ de celle-ci.

A l'instant tₙ, l'impulsion d'échantillonnage SAₙ est envoyée au convertisseur CADL qui prélève alors la valeur analogique V_{C} (pratiquement égale à V₇ à la figure 6) et la transforme en un signal digital ayant par exemple 10 bits D₀ à D₉ qui constitue le signal S envoyé à la mémoire MEMO.

Lorsque l'impulsion de décharge I_{D(n+1)} est appliquée à l'interrupteur INT, le condensateur CAP se décharge à travers cet interrupteur et sa tension aux bornes V_{C} retombe à 0. Puis le cycle recommence analogue à celui qui vient d'être décrit ci-dessus pour l'intervalle de temps compris entre l'apparition de l'impulsion I_{Dn} et celle de l'impulsion SAₙ.

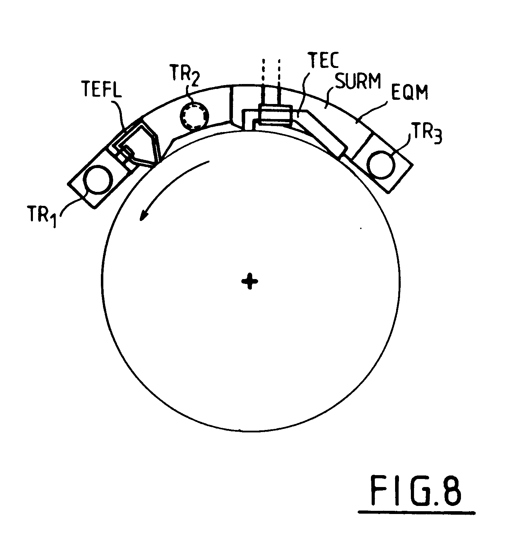

On considère les figures 7 et 8 qui montrent une forme de réalisation préférée dudit magnétomètre dynamique. Dans cette forme de réalisation, le transducteur d'écriture TEC et son surmoulage SURM (se reporter à la figure 2), et le transducteur d'effacement et de lecture TEFL sont montés sur un même bras porte-transducteur, à savoir EQM, mobile selon une direction parallèle aux génératrices du tambour TAMB. Le bras EQM se déplace selon les directions F₁ ou F₂ comme indiqué à la figure 7. Il est par exemple réalisé dans la même matière qui constitue le surmoulage SURM. Il est pourvu de deux trous TR₁ et TR₃ à l'intérieur desquels passent deux tiges cylindriques TIG₁ et TIG₂ dont l'axe est parallèle aux génératrices du tambour et sur lesquelles coulisse l'équipage mobile pour se déplacer d'une piste P, aux pistes voisines. Le bras EQM est également muni d'un trou TR₂ fileté à l'intérieur duquel passe une vis sans fin VIS solidaire de l'arbre d'entraînement d'un moteur M, par exemple de type pas-à-pas, dont le pas est égal à la largeur L des pistes P du tambour. Ainsi grâce au moteur M et la vis filetée VIS engagée à l'intérieur du trou fileté TR₂, le bras porte-tête EQM peut se déplacer le long du tambour TAMB selon une direction parallèle aux génératrices de ce dernier et l'on peut ainsi caractériser magnétiquement chaque piste P du tambour TAMB.

## Revendications

1. Procédé pour établir les caractéristiques magnétiques de première aimantation de la couche d'enregistrement d'un support magnétique d'informations mobile comportant une pluralité de pistes d'enregistrement (P) ayant chacune un index (IND) de synchronisation repéré par des moyens de repérage (MIND) qui délivrent une impulsion de synchronisation (I_{N-2}, I_{N-1}, I_{N},...) à chaque passage de l'index devant eux, dans lequel, pour chaque piste, on effectue au moins une séquence comprenant les opérations suivantes :
1) on efface magnétiquement la couche sur toute la surface de la piste de manière à rendre neutre son état magnétique,
2) on écrit ensuite sur toute cette même surface une suite de domaines magnétiques (Aᵢ, Aᵢ₊₁, Aᵢ₊₂) au moyen d'un champ magnétique (H) produit par un courant d'écriture (SC) périodique,
3) on lit ensuite à des instants d'échantillonnage déterminés (tₙ, tₙ₊₁,..) une tension (S) fonction de l'aimantation (M) à l'intérieur de chacun des domaines lus à ces instants,
4) on mémorise ces tensions et on en extrait la valeur moyenne (Sₐⱼ) et on les visualise au moyen d'un dispositif de visualisation,
caractérisé en ce que il comprend une suite de séquences distinctes au nombre de p, où p est un nombre entier, (SEQ₁, SEQ₂, SEQⱼ, ..., SEQₚ) où, lors de chaque séquence, les opérations 1) à 4) comprennent en outre les particularités suivantes :
1/ l'effacement de la couche a lieu dès réception d'une première impulsion de synchronisation (I_{N-2}),
2/ à la réception d'une seconde impulsion de synchronisation (I_{N-1}), ledit courant d'écriture (SC) a une amplitude (Iⱼ) déterminée, la suite des amplitudes (I₁, I₂, Iⱼ, ..., Iₚ) étant croissante, l'amplitude maximum (Iₚ) étant la valeur de l'amplitude (Iⱼ) pour laquelle la couche magnétique est saturée, l'amplitude minimum (I₁) étant la valeur la plus proche de zéro, le courant d'une amplitude déterminée (Iⱼ) étant appliqué lors de l'opération 2) de la séquence correspondante (SEQⱼ), dès réception de ladite seconde impulsion de synchronisation,
3/ dès réception d'une troisième impulsion de synchronisation (I_{N}), la lecture s'effectue aux dits instants d'échantillonnage avec une période d'échantillonnage déterminée (T_{E}) supérieure à la période (T) du courant d'écriture, la tension lue (S) à ces mêmes instants d'échantillonnage, étant fonction de l'aimantation (M) à l'intérieur de chacun des domaines lus à ces instants, de telle sorte qu'on obtient une pluralité de valeurs de tension lue (S) pour une même valeur d'amplitude du courant (Iⱼ),
4/ on mémorise l'ensemble des valeurs des tensions lues (S) et la valeur de l'amplitude de courant (Iⱼ) correspondante, et on extrait au moins de cet ensemble la valeur moyenne (Sₐⱼ) de la tension lue (S), la courbe moyenne de première aimantation incluant l'ensemble de ces valeurs moyennes (Sₐ₁, Sₐⱼ, ..., Sₐₚ), étant représentée en fonction de ces valeurs des amplitudes de courant (I₁, .., Iₚ) sur ledit dispositif de visualisation, dès que la dernière des séquences (SEQₚ) est terminée.

2. Procédé selon la revendication 1, caractérisé en ce que la différence de valeur entre deux amplitudes de courant correspondant à deux séquences successives, dépend des valeurs de l'amplitude maximum du courant (Iₚ) et du nombre P de séquence.

3. Procédé selon l'une des revendications 1, 2, caractérisé en ce que, on extrait également de l'ensemble des valeurs des tensions lues (S) correspondant à chacune des valeurs du courant d'écriture (Iⱼ), la valeur maximum (S_{Mj}) et la valeur minimum (Sₘⱼ), obtenant ainsi une courbe maximum de première aimantation incluant l'ensemble des valeurs maximum, et une courbe minimum de première aimantation incluant l'ensemble des valeurs minimum des tensions lues, ces deux courbes étant représentées en fonction des valeurs successives de l'amplitude du courant d'écriture (I₁ à Iₚ) sur le dispositif de visualisation.

4. Procédé selon la revendication 3, caractérisé en ce que l'on compare, au moyen du dispositif de visualisation, les courbes maximum, moyenne et minimum avec des courbes de référence maximum, moyenne, minimum (C_{R1}, C_{R}₂, C_{R3}) d'un support magnétique de référence.

## Patentansprüche

1. Verfahren zum Erstellen der magnetischen Eigenschaften einer ersten Magnetisierung der Aufzeichnungsschicht eines beweglichen magnetischen Informationsträgers, der mehrere Aufzeichnungsspuren (P) aufweist, die jeweils einen Synchronisationsindex (IND) besitzen, der von Ortungsmitteln (MIND) geortet wird, die bei jeder Vorbeibewegung des Indexes vor ihnen einen Synchronisationsimpuls (IN-2, IN-1, IN,...) ausgeben, wobei in dem Verfahren für jede Spur wenigstens eine die folgenden Operationen umfassende Sequenz ausgeführt wird:
1) magnetisches Löschen der Schicht auf der gesamten Fläche der Spur, derart, daß ihr magnetischer Zustand neutralisiert wird,
2) anschließend Beschreiben dieser gesamten Fläche mit einer Reihe von magnetischen Bereichen (Ai, Ai+1, Ai+2) mittels eines Magnetfeldes (H), das von einem periodischen Schreibstrom (SC) erzeugt wird,
3) anschließend in bestimmten Abtastzeitpunkten (tn, tn+1,...) Lesen einer Spannung (S), die von der Magnetisierung (M) im Inneren eines jeden in diesen Zeitpunkten gelesenen Bereichs abhängt,
4) Speichern dieser Spannungen und Berechnen des Mittelwertes (Saj) und Anzeigen derselben mittels einer Anzeigeeinrichtung,
dadurch gekennzeichnet, daß es eine Reihe von verschiedenen Sequenzen mit der Anzahl p umfaßt, wobei p eine ganze Zahl ist (Seq1, Seq2, Seqj,..., Seqp), wobei die Operationen 1) bis 4) in jeder Sequenz außerdem die folgenden Besonderheiten aufweisen:
1/ die Löschung der Schicht findet ab dem Empfang eines ersten Synchronisationsimpulses (IN-2) statt,
2/ beim Empfang eines zweiten Synchronisationsimpulses (IN-1) besitzt der Schreibstrom (SC) eine bestimmte Amplitude (Ij), wobei die Folge der Amplituden (I1, I2, Ij,..., Ip) anwächst, wobei die maximale Amplitude (Ip) derjenige Amplitudenwert (Ij) ist, bei dem die magnetische Schicht gesättigt ist, wobei die minimale Amplitude (I1) der am nächsten bei Null liegende Wert ist, wobei der Strom einer bestimmten Amplitude (Ij) in der Operation 2) der entsprechenden Sequenz (SEQj) ab dem Empfang des zweiten Synchronisationsimpulses zugeführt wird,
3/ ab dem Empfang eines dritten Synchronisationsimpulses (IN) wird das Lesen in den genannten Abtastzeitpunkten mit einer bestimmten Abtastperiode (TE) ausgeführt, die größer als die Periode (T) des Schreibstroms ist, wobei die gelesene Spannung (S) in diesen Abtastzeitpunkten von der Magnetisierung (M) im Inneren eines jeden der in diesen Zeitpunkten gelesenen Bereiche abhängt, derart, daß für denselben Stromamplitudenwert (Ij) mehrere Werte der gelesenen Spannung (S) erhalten werden,
4/ die Gesamtheit der Werte der gelesenen Spannungen (S) und der entsprechende Stromamplitudenwert (Ij) werden gespeichert und der Mittelwert (Saj) der gelesenen Spannung (S) wenigstens dieser Gesamtheit wird berechnet, wobei die Mittelwertkurve der ersten Magnetisierung, die die Gesamtheit dieser Mittelwerte (Sal, Saj,..., Sap) enthält, als Funktion dieser Stromamplitudenwerte (I1,..., Ip) auf der Anzeigeeinrichtung dargestellt wird, sobald die letzte der Sequenzen (SEQp) beendet ist.

2. Verfahren gemäß Anspruch 1, dadurch gekennzeichnet, daß die Wertedifferenz zwischen zwei Stromamplituden, die zwei aufeinanderfolgenden Sequenzen entsprechen, von den Werten der maximalen Stromamplitude (Ip) und von der Anzahl (p) der Sequenzen abhängt.

3. Verfahren gemäß einem der Ansprüche 1, 2, dadurch gekennzeichnet, daß außerdem aus der Gesamtheit der Werte der gelesenen Spannungen (S), die jedem der Werte des Schreibstroms (Ij) entsprechen, der Maximalwert (SMj) und der Minimalwert (Smj) berechnet werden, wodurch eine die Gesamtheit der Maximalwerte enthaltende Maximalwertkurve der ersten Magnetisierung und eine die Gesamtheit der Minimalwerte der gelesenen Spannungen enthaltende Minimalwertkurve der ersten Magnetisierung erhalten werden, wobei diese Kurven auf der Anzeigeeinrichtung in Abhängigkeit von den aufeinanderfolgenden Werten der Schreibstromamplitude (I1 bis Ip) dargestellt werden.

4. Verfahren gemäß Anspruch 3, dadurch gekennzeichnet, daß die Maximalwertkurve, die Mittelwertkurve und die Minimalwertkurve mittels der Anzeigeeinrichtung mit Maximalwert-, Mittelwert- bzw. Minimalwert-Referenzkurven (CR1, CR2, CR3) eines magnetischen Referenzträgers verglichen werden.

## Claims

1. A process for establishing the magnetic characteristics of an initial magnetisation of the recording layer of a mobile magnetic data medium comprising a plurality of recording tracks (P) each having a synchronisation indicator (IND) identified by identification means (MIND) which deliver a synchronising pulse (I_{N-2}, I_{N-1}, I_{N}, ...) each time the indicator passes in front of them, in which, for each track, at least one sequence is carried out comprising the following operations:
1) the layer is deleted magnetically over the whole surface of the track so as to make its magnetic state neutral,
2) a series of magnetic domains (A₁, A₁₊₁, A₁₊₂) is then written over the whole of this same surface by means of a magnetic field (H) produced by a periodic writing current (SC),
3) a reading is then taken, at given sampling times (tₙ, tₙ₊₁, ...), of a voltage (S) as a function of the magnetisation (M) inside each of the domains read at those times,
4) these voltages are stored and the mean value (Sₐⱼ) is extracted from them and they are displayed by means of a display device,
characterised in that it comprises a series of distinct sequences numbering p, where p is an integer, (SEQ₁, SEQ₂, SEQⱼ, ..., SEQₚ) where, during each sequence, operations (1) to (4) further comprise the following special features:
1/ deletion of the layer takes place on receipt of an initial synchronising pulse (I_{N-2}),
2/ on receipt of a second synchronising pulse (I_{N-1}), said writing current (SC) has a given amplitude (Iⱼ), the series of amplitudes (I₁, I₂, Iⱼ, ..., Iₚ) being ascending, the maximum amplitude (Iₚ) being the value of the amplitude (Iⱼ) for which the magnetic layer is saturated, the minimum amplitude (I₁) being the value closest to zero, the current of a given amplitude (Iⱼ) being applied during the operation (2) of the corresponding sequence (SEQⱼ), on receipt of said second synchronising pulse,
3/ on receipt of a third synchronising pulse (I_{N}), reading takes place at said sampling times with a given sampling period (T_{E}) greater than the period (T) of the writing current, the voltage read (S) at those same sampling times being a function of the magnetisation (M) inside each of the domains read at those times, such that a plurality of values for voltage read (S) is obtained for any one value for current amplitude (Iⱼ),
4/ the set of values for the voltages read (S) and the corresponding value for the current amplitude (Iⱼ) are stored, and the mean value (Sₐⱼ) of the voltage read (S) is extracted at least from this group, the mean curve of initial magnetisation, including all these mean values (Sₐ₁, Sₐⱼ, ..., Sₐₚ), being represented as a function of these values for current amplitude (I₁, ..., Iₚ) on said display device, as soon as the last of the sequences (SEQₚ) is completed.

2. A process according to Claim 1, characterised in that the difference in value between two current amplitudes, corresponding to two successive sequences, depends on the values for maximum current amplitude (Iₚ) and the sequence number p.

3. A process according to one of Claims 1, 2, characterised in that the maximum value (S_{Mj}) and the minimum value (Sₘⱼ) are also extracted from the whole group of values for the voltages read (S) corresponding to each of the values for the writing current (Iⱼ), thus obtaining a maximum curve for initial magnetisation including all the maximum values, and a minimum curve for initial magnetisation including all the minimum values for the voltages read, these two curves being represented as a function of the successive values for the writing current amplitude (I₁ to Iₚ) on the display device.

4. A process according to Claim 3, characterised in that the maximum, mean and minimum curves are compared by means of the display device with the reference maximum, mean and minimum curves (C_{R1}, C_{R2}, C_{R3}) of a reference magnetic medium.
